(19) Europäisches Patentamt
European Patent Office
Office européen des brevets

(11) **EP 4 686 098 A2**

(12) **EUROPEAN PATENT APPLICATION**

(43) Date of publication:
**28.01.2026 Bulletin 2026/05**

(21) Application number: **25187548.0**

(22) Date of filing: **04.07.2025**

(51) International Patent Classification (IPC):
**H03K 5/135** (2006.01)   **G11C 27/02** (2006.01)
**H03K 5/15** (2006.01)

(52) Cooperative Patent Classification (CPC):
**H03K 5/135; G11C 27/02; H03K 5/15**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **05.07.2024 US 202463667838 P**
**01.07.2025 US 202519256191**

(71) Applicant: **MEDIATEK INC.**
**Hsinchu City 30078 (TW)**

(72) Inventors:
• **PARK, Henry Arnold**
**San Jose, 95134 (US)**
• **LEE, Joon Yeong**
**San Jose, 95134 (US)**
• **ALI, Tamer Mohammed**
**San Jose, 95134 (US)**

(74) Representative: **Haseltine Lake Kempner LLP**
**Cheapside House**
**138 Cheapside**
**London EC2V 6BJ (GB)**

(54) **TRACK AND HOLD SYSTEM**

(57)     A track and hold, TAH, system (100) includes a complementary source follower circuit (102) and a first TAH path (104-1). The complementary source follower circuit receives an input signal (Vin) of the TAH system. The first TAH path includes a first TAH switch circuit (SW1), a first TAH output buffer circuit (114-1), and a first TAH clock-feedthrough cancellation circuit (112-1). The first TAH switch circuit is controlled by a first switch clock (CK1) to sample a signal derived from an output signal of the complementary source follower circuit to obtain a first sampled signal (S1). The first TAH output buffer circuit generates an output signal (Out1) of the first TAH path according to the first sampled signal. The first TAH clock-feedthrough cancellation circuit applies clock-feedthrough cancellation to the first sampled signal according to the first switch clock.

FIG. 1

## Description

### Field of the Invention

The present invention relates to a track and hold system, and more particularly, to a track and hold system using a complementary (push-pull) source follower, a built-in signal equalizer (discrete-time equalizer), clock generation with duty cycle control, and/or clock-feedthrough cancellation with amplitude control.

### Background of the Invention

A wireline SerDes (Serializer/Deserializer) system can be used for high-speed chip-to-chip communication, and may include a wireline transmitter, a channel (serial link), and a wireline receiver. A track and hold (TAH) system is commonly used in the wireline receiver for converting one high-speed serial data into multiple lower-speed parallel data. Hence, the TAH system is required to be capable of tracking a very high-speed serial input signal during a track mode. During a hold mode, the TAH output will be delivered to the next stage such as a successive-approximation register (SAR) analog-to-digital converter (ADC). Thus, there is a need for a high-speed wideband TAH system which is capable of meeting requirements of wireline SerDes applications.

### Summary of the Invention

The scope of the present invention is defined by the claims.

This in mind, the present invention aims at providing a track and hold (TAH) system using a complementary (push-pull) source follower, a built-in signal equalizer (discrete-time equalizer), clock generation with duty cycle control, and/or clock-feedthrough cancellation with amplitude control.

This is achieved by a TAH system according to any of the independent claims. The dependent claims pertain to corresponding developments and improvements.

As will be seen more clearly from the detailed description following below, a claimed TAH system includes a complementary source follower circuit and a first TAH path. The complementary source follower circuit is configured to receive an input signal of the TAH system. The first TAH path includes a first TAH switch circuit, a first TAH output buffer circuit, and a first TAH clock-feedthrough cancellation circuit. The first TAH switch circuit is controlled by a first switch clock to sample a signal derived from an output signal of the complementary source follower circuit to obtain a first sampled signal, wherein a first end of the first TAH switch circuit is coupled to an output node of the complementary source follower circuit. The first TAH output buffer circuit is coupled to a second end of the first TAH switch circuit, and configured to generate an output signal of the first TAH path according to the first sampled signal. The first TAH clock-feedthrough cancellation circuit is coupled to the second end of the first TAH switch circuit, and configured to apply clock-feedthrough cancellation to the first sampled signal according to the first switch clock.

Another claimed TAH system includes an input buffer circuit and a first TAH path. The input buffer circuit is configured to receive an input signal of the TAH system. The first TAH path includes a first TAH switch circuit, a first TAH output buffer circuit, and a first TAH clock-feedthrough cancellation circuit. The first TAH switch circuit is controlled by a first switch clock to sample a signal derived from an output signal of the input buffer circuit to obtain a first sampled signal, wherein a first end of the first TAH switch circuit is coupled to an output node of the input buffer circuit. The first TAH output buffer circuit is coupled to a second end of the first TAH switch circuit, and includes an output buffer circuit and a coupling capacitor. The output buffer circuit has an input node configured to receive the first sampled signal and an output node configured to output an output signal of the first TAH path. The coupling capacitor is coupled between the input node and the output node of the output buffer circuit. The first TAH clock-feedthrough cancellation circuit is coupled to the second end of the first TAH switch circuit, and configured to apply clock-feedthrough cancellation to the first sampled signal according to the first switch clock.

Another claimed TAH system includes an input buffer circuit, a first TAH path, a second TAH path, and a TAH switch clock generator circuit with duty cycle control. The input buffer circuit is configured to receive an input signal of the TAH system. The first TAH path includes a first TAH switch circuit, a first TAH output buffer circuit, and a first TAH clock-feedthrough cancellation circuit. The first TAH switch circuit is controlled by a first switch clock to sample a signal derived from an output signal of the input buffer circuit to obtain a first sampled signal, wherein a first end of the first TAH switch circuit is coupled to an output node of the input buffer circuit. The first TAH output buffer circuit is coupled to a second end of the first TAH switch circuit, and configured to generate an output signal of the first TAH path according to the first sampled signal. The first TAH clock-feedthrough cancellation circuit is coupled to the second end of the first TAH switch circuit, and configured to apply clock-feedthrough cancellation to the first sampled signal according to the first switch clock. The second TAH path includes a second TAH switch circuit, a second TAH output buffer circuit, and a second TAH clock-feedthrough cancellation circuit. The second TAH switch circuit is controlled by a second switch clock to sample the output signal of the input buffer circuit to obtain a second sampled signal, wherein a first end of the second TAH switch circuit is coupled to the output node of the input buffer circuit. The second TAH output buffer circuit is coupled to a second end of the second TAH switch circuit, and configured to generate an output signal of the second TAH path according to the second sampled signal. The second TAH clock-feedthrough cancellation circuit is coupled to the second end of the second TAH switch circuit, and configured to apply clock-feedthrough cancellation to the second sampled signal according to the second switch clock. The TAH switch clock generator circuit with duty cycle control is configured to generate and output the first switch clock and the second switch clock, wherein the duty cycle control is configured to control duty cycles of the first switch clock and the second switch clock, and the first switch clock and the second switch clock are non-overlapping clocks.

Another claimed TAH system includes an input buffer circuit and a first TAH path. The input buffer circuit is configured to receive an input signal of the TAH system. The first TAH path includes a first TAH switch circuit, a first TAH output buffer circuit, and a first TAH clock-feedthrough cancellation circuit. The first TAH switch circuit is controlled by a first switch clock to sample a signal derived from an output signal of the input buffer circuit to obtain a first sampled signal, wherein a first end of the first TAH switch circuit is coupled to an output node of the input buffer circuit. The first TAH output buffer circuit is coupled to a second end of the first TAH switch circuit, and configured to generate an output signal of the first TAH path according to the first sampled signal. The first TAH clock-feedthrough cancellation circuit is coupled to the second end of the first TAH switch circuit, and includes an inverter circuit, a voltage divider circuit, and a coupling capacitor. The inverter circuit is configured to receive the first switch clock. The voltage divider circuit is configured to apply voltage division to an output of the inverter circuit to generate an amplitude-controlled clock. The coupling capacitor is coupled between the amplitude-controlled clock output from the voltage divider circuit and the first sampled signal output from the first TAH switch circuit.

Brief Description of the Drawings

In the following, the invention is further illustrated by way of example, taking reference to the accompanying drawings. Thereof

FIG. 1 is a diagram illustrating a track and hold (TAH) system according to an embodiment of the present invention,
FIG. 2 is a diagram illustrating an example of using a clock generator with duty cycle control to generate non-overlapping switch clocks CK1-CKN (N=4) according to multi-phase clocks CK0°, CK90°, CK180°, CK270°,
FIG. 3 is a diagram illustrating another example of using a clock generator with duty cycle control to generate non-overlapping switch clocks CK1-CKN (N=4),
FIG. 4 is a diagram illustrating the proposed TAH clock-feedthrough cancellation performed under a condition that a TAH switch circuit is a PMOS transistor switch, and
FIG. 5 is a diagram illustrating the proposed TAH clock-feedthrough cancellation performed under a condition that a TAH switch circuit is an NMOS transistor switch.

Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

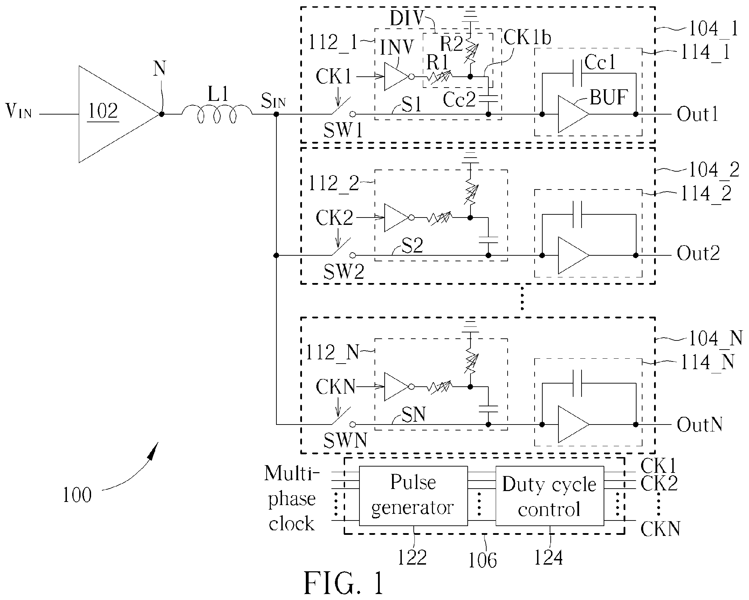

FIG. 1 is a diagram illustrating a track and hold (TAH) system according to an embodiment of the present invention. The TAH system 100 may be a part of a wireline receiver in a wireline SerDes system. However, this is for illustrative purposes only, and is not meant to be a limitation of the present invention. In practice, any signal processing circuit using the TAH system 100 falls within the scope of the present invention. The TAH system 100 may include an input buffer circuit 102, a series peaking inductor L1, a plurality of TAH paths 104_1-104_N (N≥2), and a TAH switch clock generator circuit 106. The input buffer circuit 102 is configured to receive an input signal (e.g., a high-speed serial input data) $V_{IN}$ of the TAH system 100. In this embodiment, the input buffer circuit 102 is implemented using a complementary (push-pull) source follower circuit. For example, the complementary (push-pull) source follower circuit includes two transistors, where one of the transistors is an N-channel metal-oxide-semiconductor (NMOS) transistor acting as an N-type source follower, and the other of the transistors is a P-channel metal-oxide-semiconductor (PMOS) transistor acting as a P-type source follower. The complementary (push-pull) source follower has several advantages, including a large gain, low output impedance, high power efficiency, etc. The TAH system 100 can benefit from advantages of the complementary (push-pull) source follower circuit that is used as the input buffer circuit 102. In addition, a proper biasing technique may be employed to program a bias current of the complementary (push-pull) source follower circuit as well as an output common-mode voltage of the complementary (push-pull) source follower circuit.

The TAH paths 104_1-104_N (N ≥ 2) are configured to generate and output a plurality of output signals Out1-OutN of the TAH system 100, respectively. Each of the TAH paths 104_1-104_N may have the same circuit structure. As shown in FIG. 1, the TAH path 104_1 includes a TAH switch circuit SW1, a TAH clock-feedthrough cancellation circuit 112_1, and an output buffer circuit 114_1; the TAH path 104_2 includes a TAH switch circuit SW2, a TAH clock-feedthrough cancellation circuit 112_2, and an output buffer circuit 114_2; and the TAH path 104_N includes a TAH switch circuit SWN, a TAH clock-feedthrough cancellation circuit 112_N, and an output buffer circuit 114_N.

In this embodiment, the series peaking inductor L1 is coupled between the output node N of the input buffer circuit 102 and a first end of a TAH switch circuit included in each of the TAH paths 104_1-104_N for bandwidth extension. For example, the series peaking inductor L1 may be implemented by an inductor with low inductance (e.g., 0<L1<100nH). It should be noted that the series peaking inductor L1 may be optional. In some embodiments of the present invention, the series peaking inductor L1 may be replaced by a short-circuit (e.g., L1=0) between the output node N of the input buffer circuit 102 and the first end of the TAH switch circuit included in each of the TAH paths 104_1-104_N.

The TAH switch circuits SW1-SWN are driven by the same input buffer circuit (e.g., complementary source follower circuit) 102. The TAH switch circuit SW1 is controlled by a switch clock CK1 to sample a signal $S_{IN}$ derived from an output signal of the input buffer circuit 102 to obtain a sampled signal S1. The TAH switch circuit SW2 is controlled by a switch clock CK2 to sample the signal $S_{IN}$ derived from the output signal of the input buffer circuit 102 to obtain a sampled signal S2. The TAH switch circuit SWN is controlled by a switch clock CKN to sample the signal $S_{IN}$ derived from the output signal of the input buffer circuit 102 to obtain a sampled signal SN. The switch clocks CK1-CKN may have the same frequency but different phases. In this embodiment, only one of the TAH switch circuits SW1-SWN is allowed to be switched on (i.e., closed) at a time. Hence, the TAH switch clock generator circuit 106 is configured to generate and output non-overlapping clocks as the switch clocks CK1-CKN. Since the switch clocks CK1-CKN are non-overlapping clocks, the memory effect and the nonlinear distortion caused by overlapping of TAH clocks can be avoided.

In this embodiment, the TAH switch clock generator circuit 106 employs duty cycle control to properly control duty cycles of switch clocks CK1-CKN for ensuing that the switch clocks CK1-CKN are non-overlapping clocks. For example, the TAH switch clock generator circuit 106 may include a pulse generator 122 and a duty cycle control mechanism (labeled by "duty cycle control") 124. The pulse generator 122 receives multi-phase clocks (i.e., clocks with the same frequency but difference phases) and generates one TAH clock pulse by combining two input clocks' edges. For example, the pulse generator 122 may be a logic gate such as a NAND gate or a NOR gate. The following duty cycle control mechanism 124 controls the clock edge's transition time to ensure that clock pulses (i.e., logic-high pulses) of the switch clocks CK1-CKN do not overlap in the time domain.

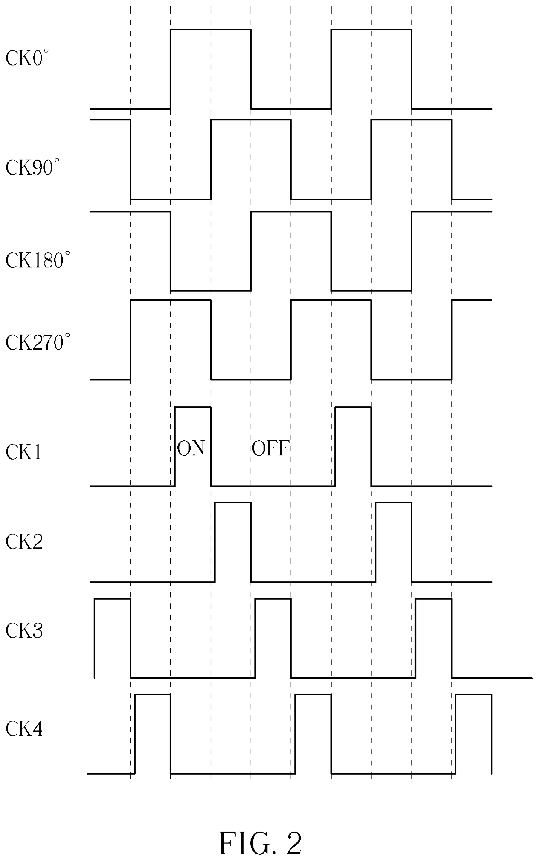

FIG. 2 is a diagram illustrating an example of using a clock generator with duty cycle control to generate non-overlapping switch clocks CK1-CKN (N=4) according to multi-phase clocks CK0°, CK90°, CK180°, CK270°. Suppose that the TAH switch circuits SW1-SWN are implemented using NMOS transistors. A switch clock applied to each of the TAH switch circuits (i.e., NMOS transistor switches) SW1-SWN is constrained to have a duty cycle not larger than 100%/N. As shown in FIG, 2, the duty cycle of each of the switch clocks CK1-CKN (N=4) is equal to or smaller than 25% (i.e., $\frac{100\%}{4}$).

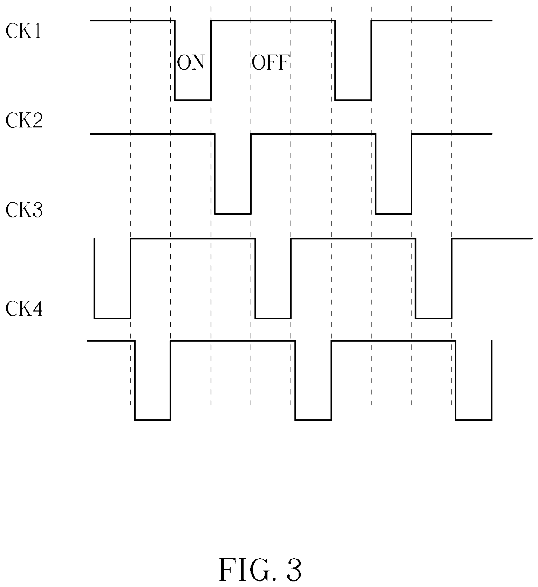

FIG. 3 is a diagram illustrating another example of using a clock generator with duty cycle control to generate non-overlapping switch clocks CK1-CKN (N=4). Suppose that the TAH switch circuits SW1-SWN are implemented using PMOS transistors. A switch clock applied to each of the TAH switch circuits (i.e., PMOS transistor switches) SW1-SWN is constrained to have a duty cycle not smaller than 100%*(N-1)/N. As shown in FIG, 3, the duty cycle of each of the switch clocks CK1-CKN (N=4) is equal to or larger than 75% (i.e., $100\% * \frac{3}{4}$).

In this embodiment, the pulse generator 122 and the duty cycle control mechanism 124 of the TAH switch clock generator circuit 106 are separate circuit blocks. However, this is for illustrative purposes only, and is not meant to be a limitation of the present invention. In practice, the present invention has no limitations on implementation of the duty cycle control. In some embodiments of the present invention, the TAH switch clock generator circuit 106 may be modified to have duty cycle control integrated inside a pulse generator. The same objective of using duty cycle control to generate non-overlapping switch clocks CK1-CKN can be achieved.

The TAH clock-feedthrough cancellation circuit 112_1 is coupled to a second end of the TAH switch circuit SW1, and configured to apply clock-feedthrough cancellation to the sampled signal S1 according to the switch clock CK1. The TAH clock-feedthrough cancellation circuit 112_2 is coupled to a second end of the TAH switch circuit SW2, and configured to apply clock-feedthrough cancellation to the sampled signal S2 according to the switch clock CK2. The TAH clock-feedthrough cancellation circuit 112_N is coupled to a second end of the TAH switch circuit SWN, and configured to apply clock-feedthrough cancellation to the sampled signal SN according to the switch clock CKN. In this embodiment, each of the TAH clock-feedthrough cancellation circuits 112_1-112_N (N ≥ 2) is capable of providing clock-feedthrough cancellation with amplitude control. Taking the TAH clock-feedthrough cancellation circuit 112_1 for example, it includes an inverter circuit INV, a voltage divider circuit DIV, and a coupling capacitor $C_C2$. The inverter circuit INV is configured to receive the switch clock SW1. The voltage divider circuit DIV acts as an amplitude control mechanism, and is configured to apply voltage division to an output of the inverter circuit INV (i.e., an inverse version of the switch clock SW1) to generate an amplitude-controlled clock CK1b. The coupling capacitor $C_C2$ is coupled between the amplitude-controlled clock CK1b output from the voltage divider circuit DIV and the sampled signal S1 output from the TAH switch circuit SW1. For example, the coupling capacitor $C_C2$ may be implemented using a metal-oxide-metal capacitor.

As shown in FIG. 1, the voltage divider circuit DIV is implemented using two series resistors R1 and R2. Hence, the amplitude of the amplitude-controlled clock CK1b can be controlled/adjusted by the series resistors R1 and R2. In other words, the amplitude of the amplitude-controlled clock CK1b may be different from that of the switch clock SW1. With proper resistance settings of resistors R1 and R2, the output signal Out1 with optimized clock-feedthrough cancellation can be generated. For example, the voltage divider circuit DIV may be implemented using a programmable resistor divider circuit, such that resistance of resistors R1 and R2 can be programmed to enable an optimized clock-feedthrough cancellation effect.

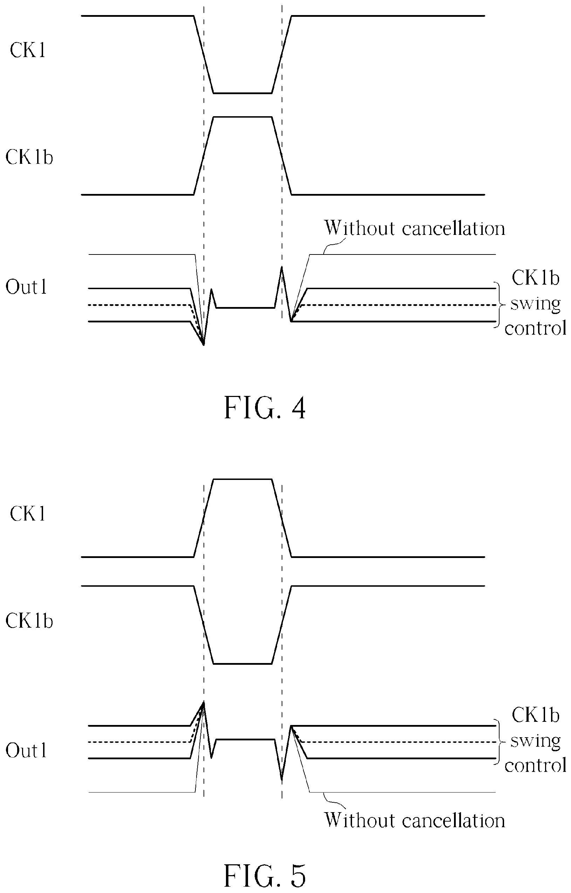

FIG. 4 is a diagram illustrating the proposed TAH clock-feedthrough cancellation performed under a condition that a TAH switch circuit is a PMOS transistor switch. The clock transitions of the switch clock CK1 may be coupled to the output signal Out1 through capacitance of the TAH switch circuit (e.g., MOS switch) SW1. With a proper amplitude control of the amplitude-controlled clock CK1b, the effect of clock-feedthrough can be suppressed.

FIG. 5 is a diagram illustrating the proposed TAH clock-feedthrough cancellation performed under a condition that a TAH switch circuit is an NMOS transistor switch. The clock transitions of the switch clock CK1 may be coupled to the output signal Out1 through capacitance of the TAH switch circuit (e.g., MOS switch) SW1. With a proper amplitude control of the amplitude-controlled clock CK1b, the effect of clock-feedthrough can be suppressed.

The output buffer circuit 114_1 is coupled to the second end of the TAH switch circuit SW1, and configured to generate the output signal Out1 of the TAH path 104_1 according to the sampled signal S1. The output buffer circuit 114_2 is coupled to the second end of the TAH switch circuit SW2, and configured to generate the output signal Out2 of the TAH path 104_2 according to the sampled signal S2. The output buffer circuit 114_N is coupled to the second end of the TAH switch circuit SWN, and configured to generate the output signal Out1 of the TAH path 104_N according to the sampled signal SN. In this embodiment, each of the output buffer circuits 114_1-114_N (N ≥ 2) may be configured to act as a built-in signal equalizer (discrete-time equalizer) of the TAH system 100. Taking the output buffer circuit 114_1 for example, it includes an output buffer circuit BUF and a coupling capacitor $C_C1$. The output buffer circuit BUF has an input node configured to receive the sampled signal S1 and an output node configured to output the output signal Out1 of the TAH path 104_1. The coupling capacitor $C_C1$ is coupled between the input node and the output node of the output buffer circuit BUF, and can be used to amplify the high-frequency band signal. For example, the coupling capacitor $C_C1$ with larger capacitance can boost the high-frequency gain. The coupling capacitor $C_C1$ may be implemented using a device parasitic capacitor, a MOS capacitor, or a metal-oxide-metal capacitor.

The TAH system 100 uses all technical features proposed by the present invention, including a complementary (push-pull) source follower that acts as an input buffer, a built-in signal equalizer (discrete-time equalizer) included in each TAH path, clock generation with duty cycle control, and clock-feedthrough cancellation with amplitude control. However, this is for illustrative purposes only, and is not meant to be a limitation of the present invention. In practice, any TAH system using one or some of the technical features proposed by the present invention falls within the scope of the present invention. In a first alternative design, the TAH system 100 may be modified to replace the complementary (push-pull) source follower of the input buffer circuit 102 by a different amplifier topology. In a second alternative design, the TAH system 100 may be modified to omit the voltage divider circuit in each of the TAH clock-feedthrough cancellation circuits 112_1-112_N. In a third alternative design, the TAH system 100 may be modified to omit the duty cycle control mechanism in the TAH switch clock generator circuit 106. In a fourth alternative design, the TAH system 100 may be modified to omit the coupling capacitor in each of the TAH output buffer circuits 114_1-114_N.

**Claims**

1. A track and hold, hereinafter referred to as TAH, system (100) **characterized by**:

   a complementary source follower circuit (102), configured to receive an input signal ($V_{IN}$) of the TAH system (100); and
   a first TAH path (104_1), comprising:

   a first TAH switch circuit (SW1), controlled by a first switch clock (CK1) to sample a signal ($S_{IN}$) derived from an output signal of the complementary source follower circuit (102) to obtain a first sampled signal (S1), wherein a first end of the first TAH switch circuit (SW1) is coupled to an output node (N) of the complementary source follower circuit (102);
a first TAH output buffer circuit (114_1), coupled to a second end of the first TAH switch circuit (SW1), wherein the first TAH output buffer circuit (114_1) is configured to generate an output signal (Out1) of the first TAH path (104_1) according to the first sampled signal (S1); and
a first TAH clock-feedthrough cancellation circuit (112_1), coupled to the second end of the first TAH switch circuit (SW1), wherein the first TAH clock-feedthrough cancellation circuit (112_1) is configured to apply clock-feedthrough cancellation to the first sampled signal (S1) according to the first switch clock (CK1).

2. The TAH system (100) of claim 1, **characterized in that** the TAH system (100) further comprises:
a series peaking inductor (L1), coupled between the output node of the complementary source follower circuit (102) and the first end of the first TAH switch circuit (SW1).

3. The TAH system (100) of claim 1, **characterized in that** the first TAH output buffer circuit (114_1) comprises:

an output buffer circuit (BUF), having an input node configured to receive the first sampled signal (S1) and an output node configured to output the output signal (Out1) of the first TAH path (104_1); and
a coupling capacitor ($C_C1$), coupled between the input node and the output node of the output buffer circuit (BUF).

4. The TAH system (100) of claim 1, **characterized in that** the TAH system (100) further comprises:
a second TAH path (104_2), comprising:

a second TAH switch circuit (SW2), controlled by a second switch clock (CK2) to sample the signal ($S_{IN}$) derived from the output signal of the complementary source follower circuit (102) to obtain a second sampled signal (S2), wherein a first end of the second TAH switch circuit (SW2) is coupled to the output node (N) of the complementary source follower circuit (102), and the first switch clock (CK1) and the second switch clock (CK2) are non-overlapping clocks;
a second TAH output buffer circuit (114_2), coupled to a second end of the second TAH switch circuit (SW2), wherein the second TAH output buffer circuit (114_2) is configured to generate an output signal (Out2) of the second TAH path (104_2) according to the second sampled signal (S2); and
a second TAH clock-feedthrough cancellation circuit (112_2), coupled to the second end of the second TAH switch circuit (SW2), wherein the second TAH clock-feedthrough cancellation circuit (112_2) is configured to apply clock-feedthrough cancellation to the second sampled signal (S2) according to the second switch clock (CK2).

5. The TAH system (100) of claim 4, **characterized in that** the TAH system (100) further comprises:
a TAH switch clock generator circuit (106) with duty cycle control, configured to generate and output the first switch clock (CK1) and the second switch clock (CK2), wherein the duty cycle control is configured to control duty cycles of the first switch clock (CK1) and the second switch clock (CK2).

6. The TAH system (100) of claim 5, **characterized in that** the TAH system (100) comprises N TAH switch circuits (SW1, SW2, SWN) driven by the complementary source follower circuit (102), each of the N TAH switch circuits (SW1, SW2, SWN) is a P-channel metal-oxide-semiconductor transistor, and a switch clock (CK1, CK2, CKN) applied to each of the N TAH switch circuits (SW1, SW2, SWN) has a duty cycle not smaller than 100%*(N-1)/N.

7. The TAH system (100) of claim 5, **characterized in that** the TAH system (100) comprises N TAH switch circuits (SW1, SW2, SWN) driven by the complementary source follower circuit (102), each of the N TAH switch circuits (SW1, SW2, SWN) is an N-channel metal-oxide-semiconductor transistor, and a switch clock (CK1, CK2, CKN) applied to each of the N TAH switch circuits (SW1, SW2, SWN) has a duty cycle not larger than 100%/N.

8. The TAH system (100) of claim 1, **characterized in that** the first TAH clock-feedthrough cancellation circuit (112_1) comprises:

an inverter circuit (INV), configured to receive the first switch clock (CK1);
a voltage divider circuit (DIV), configured to apply voltage division to an output of the inverter circuit (INV) to generate an amplitude-controlled clock (CK1b); and
a coupling capacitor ($C_C2$), coupled between the amplitude-controlled clock (CK1b) output from the voltage divider circuit (DIV) and the first sampled signal (S1) output from the first TAH switch circuit (SW1).

9. A track and hold, hereinafter referred to as TAH, system (100) **characterized by**:

an input buffer circuit (102), configured to receive an input signal ($V_{IN}$) of the TAH system (100); and
a first TAH path (104_1), comprising:

a first TAH switch circuit (SW1), controlled by a first switch clock (CK1) to sample a signal ($S_{IN}$) derived from an output signal of the input circuit (102) to obtain a first sampled signal (S1), wherein a first end of the first TAH switch circuit (SW1) is coupled to an output node of the input buffer circuit (102);
a first TAH output buffer circuit (114_1), coupled to a second end of the first TAH switch circuit (SW1), wherein the first TAH output buffer circuit (114_1) comprises:

an output buffer circuit (BUF), having an input node configured to receive the first sampled signal (S1) and an output node configured to output an output signal (Out1) of the first TAH path (104_1); and
a coupling capacitor ($C_C1$), coupled between the input node and the output node of the output buffer circuit (BUF); and

a first TAH clock-feedthrough cancellation circuit (112_1), coupled to the second end of the first TAH switch circuit (SW1), wherein the first TAH clock-feedthrough cancellation circuit (112_1) is configured to apply clock-feedthrough cancellation to the first sampled signal (S1) according to the first switch clock (CK1).

10. A track and hold, hereinafter referred to as TAH, system (100) **characterized by**:

an input buffer circuit (102), configured to receive an input signal ($V_{IN}$) of the TAH system (100);
a first TAH path (104_1), comprising:

a first TAH switch circuit (SW1), controlled by a first switch clock (CK1) to sample a signal ($S_{IN}$) derived from an output signal of the input buffer circuit (102) to obtain a first sampled signal (S1), wherein a first end of the first TAH switch circuit (SW1) is coupled to an output node of the input buffer circuit (102);
a first TAH output buffer circuit (114_1), coupled to a second end of the first TAH switch circuit (SW1), wherein the first TAH output buffer circuit (114_1) is configured to generate an output signal (Out1) of the first TAH path (104_1) according to the first sampled signal (S1); and
a first TAH clock-feedthrough cancellation circuit (112_1), coupled to the second end of the first TAH switch circuit (SW1), wherein the first TAH clock-feedthrough cancellation circuit (112_1) is configured to apply clock-feedthrough cancellation to the first sampled signal (S1) according to the first switch clock (CK1);

a second TAH path (104_2), comprising:

a second TAH switch circuit (SW2), controlled by a second switch clock (CK2) to sample the signal ($S_{IN}$) derived from the output signal of the input buffer circuit (102) to obtain a second sampled signal (S2), wherein a first end of the second TAH switch circuit (SW2) is coupled to the output node of the input buffer circuit (102);
a second TAH output buffer circuit (114_2), coupled to a second end of the second TAH switch circuit (SW2), wherein the second TAH output buffer circuit (114_2) is configured to generate an output signal (Out2) of the second TAH path (104_2) according to the second sampled signal (S2); and
a second TAH clock-feedthrough cancellation circuit (112_2), coupled to the second end of the second TAH switch circuit (SW2), wherein the second TAH clock-feedthrough cancellation circuit (112_2) is configured to apply clock-feedthrough cancellation to the second sampled signal (S2) according to the second switch clock (CK2); and

a TAH switch clock generator circuit (106) with duty cycle control, configured to generate and output the first switch clock (CK1) and the second switch clock (CK2), wherein the duty cycle control is configured to control duty cycles of the first switch clock (CK1) and the second switch clock (CK2), and the first switch clock (CK1) and the second switch clock (CK2) are non-overlapping clocks.

11. The TAH system (100) of claim 10, **characterized in that** the TAH system (100) comprises N TAH switch circuits (SW1, SW2, SWN) driven by the input buffer circuit (102), each of the N TAH switch circuits (SW1, SW2, SWN) is a P-channel metal-oxide-semiconductor transistor, and a switch clock (CK1, CK2, CKN) applied to each of the N TAH switch circuits (SW1, SW2, SWN) has a duty cycle not smaller than 100%*(N-1)/N.

12. The TAH system (100) of claim 10, **characterized in that** the TAH system (100) comprises N TAH switch circuits (SW1, SW2, SWN) driven by the input buffer circuit (102), each of the N TAH switch circuits (SW1, SW2, SWN) is an N-channel metal-oxide-semiconductor transistor, and a switch clock (CK1, CK2, CKN) applied to each of the N TAH switch circuits (SW1, SW2, SWN) has a duty cycle not larger than 100%/N.

13. A track and hold, hereinafter referred to as TAH, system (100) **characterized by**:

   an input buffer circuit (102), configured to receive an input signal ($V_{IN}$) of the TAH system (100); and
   a first TAH path (104_1), comprising:

      a first TAH switch circuit (SW1), controlled by a first switch clock (CK1) to sample a signal ($S_{IN}$) derived from an output signal of the input buffer circuit (102) to obtain a first sampled signal (S1), wherein a first end of the first TAH switch circuit (SW1) is coupled to an output node of the input buffer circuit (102);
      a first TAH output buffer circuit (114_1), coupled to a second end of the first TAH switch circuit (SW1), wherein the first TAH output buffer circuit (114_1) is configured to generate an output signal (Out1) of the first TAH path (104_1) according to the first sampled signal (S1); and
      a first TAH clock-feedthrough cancellation circuit (112_1), coupled to the second end of the first TAH switch circuit (SW1), wherein the first TAH clock-feedthrough cancellation circuit (112_1) comprises:

         an inverter circuit (INV), configured to receive the first switch clock (CK1);
         a voltage divider circuit (DIV), configured to apply voltage division to an output of the inverter circuit (INV) to generate an amplitude-controlled clock (CK1b); and
         a coupling capacitor ($C_C2$), coupled between the amplitude-controlled clock (CK1b) output from the voltage divider circuit (DIV) and the first sampled signal (S1) output from the first TAH switch circuit (SW1).

14. The TAH system (100) of any of claims 8 and 13, **characterized in that** the voltage divider circuit (DIV) is a programmable resistor divider circuit.

15. The TAH system (100) of any of claims 1, 9, 10 and 13, **characterized in that** the TAH system (100) is a part of a wireline receiver.

FIG. 1

FIG. 2

FIG. 3

FIG. 4

FIG. 5